(19) Europäisches Patentamt
European Patent Office
Office européen des brevets

(11) EP 3 640 302 A1

(12) **EUROPEAN PATENT APPLICATION**
published in accordance with Art. 153(4) EPC

(43) Date of publication:
**22.04.2020 Bulletin 2020/17**

(21) Application number: **18817824.8**

(22) Date of filing: **26.04.2018**

(51) Int Cl.:
***C08L 83/07*** *(2006.01)*
***C08K 3/36*** *(2006.01)*
***C08K 9/06*** *(2006.01)*
***C08L 83/04*** *(2006.01)*
***C08L 83/05*** *(2006.01)*

(86) International application number:
**PCT/JP2018/017012**

(87) International publication number:
**WO 2018/230179 (20.12.2018 Gazette 2018/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.06.2017 JP 2017118138**
**05.07.2017 JP 2017132213**

(71) Applicant: **Shin-Etsu Chemical Co., Ltd.**
**Tokyo 100-0004 (JP)**

(72) Inventors:
- **KITAGAWA Taichi**
**Annaka-shi**
**Gunma 379-0224 (JP)**
- **MATSUMOTO Nobuaki**
**Annaka-shi**
**Gunma 379-0224 (JP)**
- **MATSUMURA Kazuyuki**
**Annaka-shi**
**Gunma 379-0224 (JP)**
- **YAGINUMA Atsushi**
**Annaka-shi**
**Gunma 379-0224 (JP)**

(74) Representative: **Wibbelmann, Jobst**
**Wuesthoff & Wuesthoff**
**Patentanwälte PartG mbB**
**Schweigerstrasse 2**
**81541 München (DE)**

(54) **SILICONE COMPOSITION AND PRODUCTION METHOD FOR SAME**

(57) The present invention is a silicone composition that includes: (A) 100 parts by mass of an organopolysiloxane having the viscosity at 25°C of 0.01 to 100 Pa·s and two or more alkenyl groups bonded to a silicon atom in one molecule; (B) 1 to 500 parts by mass of a silicone resin having at least one of a $SiO_{4/2}$ unit and a $R^1SiO_{3/2}$ unit; (C) 10 to 500 parts by mass of hydrophobic silica particles having an average particle diameter in the range of 20 nm to 1,000 nm, and the degree of hydrophobization due to a methanol titrimetric method of 60% or larger; (D) an organohydrogenpolysiloxane having two or more hydrogen atoms bonded to a silicon atom in one molecule, in an amount to provide 0.4 to 5.0 mol of the silicon-bonded hydrogen atoms within the (D) component for every 1 mol of a total of the alkenyl groups bonded to all silicon atoms in the composition; and (E) an effective amount of a platinum group metal catalyst. Thereby, the silicone composition having excellent fluidity, and high transparency and high tear strength after curing is provided.

EP 3 640 302 A1

**Description**

TECHNICAL FIELD

The present invention relates to a silicone composition and its production method.

BACKGROUND ART

A silicone rubber has excellent heat resistance, cold resistance and electric insulation, and is widely used in industries such as electricity/electronics, automobiles and constructions. A potting material is used for protection of electric/electronic components and high fluidity is required to fill every fine corners. Furthermore, in recent years, when a defect occurred in the electric/electronic components that are protected by the potting material, it is desired that the potting material itself has high transparency in order to be able to instantly find where the defect is. Although a silicone gel has been proposed as a potting material having high transparency, it lacks in the mechanical strength due to gel state (Patent Document 1). Since due to thermal expansion of a component accompanying high heat generation, there is a problem that the stress is applied on the potting material to generate cracks, the high mechanical strength is required. With an improvement of the mechanical strength as an object, a silicone composition in which a reinforcement agent such as silica particles or a silicone resin is blended is also proposed (Patent Documents 2,3). However, when the silica particles of which surface is not hydrophobized or insufficiently hydrophobized are used, since the viscosity and thixotropy become high and the fluidity drops, the fillability into detail becomes poor. Furthermore, the dispersibility is also low to be cloudy and the transparency is poor. Furthermore, when only a silicone resin is used for the reinforcement agent, while the transparency can be secured, a degree of improvement of the mechanical strength is low and the sufficient strength cannot be obtained. Furthermore, although there is a proposal of a high thermal conductive silicone composition having high transparency by using sol-gel silica of which surface is hydrophobized, the mechanical strength is insufficient (Patent Document 4).

Prior Art

PATENT LITERATURE

Patent Document 1: Japanese Patent Laid-Open Publication No. 2008-231247
Patent Document 2: Japanese Patent Laid-Open Publication No. 2000-351901
Patent Document 3: Japanese Patent Laid-Open Publication No. 2013-64089
Patent Document 4: Japanese Patent Laid-Open Publication No. 2012-144595

SUMMARY OF INVENTION

TECHNICAL PROBLEM

Recently, it has been desired to develop a high strength silicone potting material that has high fluidity, excellent fillability, high transparency to enable to observe the inside of the potting, and does not generate crack even when stress is applied.

The present invention was carried out in view of the above situation and intends to provide a silicone composition that has excellent fluidity, high transparency and high tear strength after curing, and its production method.

SOLUTION TO PROBLEM

In order to solve the above problem, the present invention provides a silicone composition including the following (A) to (E) components:

(A) 100 parts by mass of an organopolysiloxane having the viscosity at 25°C of 0.01 to 100 Pa·s and two or more alkenyl groups bonded to a silicon atom in one molecule;
(B) 1 to 500 parts by mass of a silicone resin having at least one of a $SiO_{4/2}$ unit and a $R^1SiO_{3/2}$ unit ($R^1$ is a nonsubstituted or substituted monovalent hydrocarbon group);
(C) 10 to 500 parts by mass of hydrophobic silica particles having an average particle diameter in the range of 20 nm to 1,000 nm, and the degree of hydrophobization due to a methanol titrimetric method of 60% or larger;

(D) an organohydrogenpolysiloxane having two or more hydrogen atoms bonded to a silicon atom in one molecule, in an amount to provide 0.4 to 5.0 mol of the silicon-bonded hydrogen atoms within the (D) component for every 1 mol of a total of the alkenyl groups bonded to all silicon atoms in the composition; and
(E) an effective amount of a platinum group metal catalyst.

The silicone composition like the present invention becomes a silicone composition that has excellent fluidity, and high transparency and high tear strength after being cured.
At this time, the (C) component is preferable to be one having an $R^2SiO_{3/2}$ unit ($R^2$ is a substituted or nonsubstituted monovalent hydrocarbon group having 1 to 20 carbon atoms) and an $R^3{}_3SiO_{1/2}$ unit ($R^3$ is the same or different kind of substituted or nonsubstituted monovalent hydrocarbon group having 1 to 6 carbon atoms) on a silica surface.
The (C) component containing the unit like this can improve the hydrophobicity and can be preferably used in the silicone composition of the present invention.
Furthermore, one containing 0.01 to 5.0 parts by mass of (F) a reaction control agent based on 100 parts by mass of the (A) component is preferable.
The silicone composition of the present invention may have the reaction control agent like this.
Furthermore, the present invention provides a method for producing the silicone composition according to any one of claim 1 to 3, includes a process of producing the (C) component by steps containing the following (α), (β) and (γ), and a process of mixing at least the (C) component and the (A), (B), (D), and (E) components:

(α) a step of obtaining a dispersion of hydrophilic silica particles by hydrolyzing and condensing at least one of a four-functional silane compound represented by the following general formula (I) and alkyl silicate represented by the following general formula (II) under the presence of a basic substance, in a mixed solution of a hydrophilic organic solvent and water,

$$Si(OR^4)_4 \qquad (I)$$

$$Si(OR^4)_3\text{-}(\text{-}SiO(OR^4)_2\text{-})_m\text{-}Si(OR^4)_3 \qquad (II)$$

wherein, $R^4$ is the same or different kind of monovalent hydrocarbon group having 1 to 6 carbon atoms, m is 1 to 100;
(β) a step of obtaining a dispersion of silica particles that are an intermediate of the (C) component by treating a surface of the hydrophilic silica particles by adding at least one of a three-functional silane compound represented by the following general formula (III) and its (partial)hydrolysis condensate in the obtained mixed solvent dispersion of the hydrophilic silica particles,

$$R^2Si(OR^5)_3 \qquad (III)$$

wherein, $R^2$ is a substituted or nonsubstituted monovalent hydrocarbon group having 1 to 20 carbon atoms, and $R^5$ is the same or different kind of monovalent hydrocarbon group having 1 to 6 carbon atoms;
(γ) a step of obtaining hydrophobic silica particles of the (C) component, by treating a surface of silica particles that are an intermediate of the (C) component by adding at least one of a silazane compound represented by the following general formula (IV) and a monofunctional silane compound represented by the following general formula (V) in the obtained mixed solvent dispersion of the silica particles that are an intermediate of the (C) component,

$$R^3{}_3SiNHSiR^3{}_3 \qquad (IV)$$

$$R^3{}_3SiX \qquad (V)$$

wherein, $R^3$ is the same or different kind of substituted or nonsubstituted monovalent hydrocarbon group having 1 to 6 carbon atoms, and X is an OH group or a hydrolyzable group.

A production method including processes like this may readily produce a silicone composition having excellent fluidity, and high transparency and high tear strength after being cured.

## ADVANTAGEOUS EFFECTS OF INVENTION

As was described above, the silicone compound of the present invention becomes a silicone composition having

high fluidity, and having high transparency and high tear strength after curing. The silicone composition of the present invention like this may be used in applications that require the fluidity and transparency, and high tear strength. For instance, it may be used as an optical lens member, or a potting material for electronic component protection, which is required to have the internal visibility and crack resistance. That is, when the silicone composition of the present invention is used as a protective potting material of a heat-generating fine electronic component, after curing, one having the internal visibility that can find a damaged site of the component and mechanical strength capable of suppressing crack that may be generated by a thermal stress.

DESCRIPTION OF EMBODIMENTS

As was described above, a silicone composition having excellent fluidity, and high transparency and high tear strength after curing has been demanded.

The present inventors, after studying hard to achieve the above object, found that by containing a silicone resin and silica particles of which surface is highly hydrophobized, a silicone composition having excellent fluidity, and high transparency and high tear strength after curing is formed, and completed the present invention.

That is, the present invention is a silicone composition including the following (A) to (E) components:

(A) 100 parts by mass of an organopolysiloxane having the viscosity at 25°C of 0.01 to 100 Pa·s and two or more alkenyl groups bonded to a silicon atom in one molecule;
(B) 1 to 500 parts by mass of a silicone resin having at least one of a $SiO_{4/2}$ unit and a $R^1SiO_{3/2}$ unit ($R^1$ is a nonsubstituted or substituted monovalent hydrocarbon group);
(C) 10 to 500 parts by mass of hydrophobic silica particles having an average particle diameter in the range of 20 nm to 1,000 nm, and the degree of hydrophobization due to a methanol titrimetric method of 60% or larger;
(D) an organohydrogenpolysiloxane having two or more hydrogen atoms bonded to a silicon atom in one molecule, in an amount to provide 0.4 to 5.0 mol of the silicon-bonded hydrogen atoms within the (D) component for every 1 mol of a total of the alkenyl groups bonded to all silicon atoms in the composition; and
(E) an effective amount of a platinum group metal catalyst.

Although in what follows, a detailed description of the present invention will be given, the present invention is not limited thereto.

A silicone composition of the present invention includes (A) an organopolysiloxane having two or more of alkenyl groups bonded to a silicon atom in one molecule, (B) a silicone resin made of a $SiO_{4/2}$ unit and/or a $R^1SiO_{3/2}$ unit, (C) hydrophobic silica particles having a particle size in the range of 20 nm to 1000 nm and the degree of hydrophobization due to a methanol titrimetric method of 60% or larger, (D) an organohydrogenpolysiloxane having two or more hydrogen atoms bonded to a silicon atom in one molecule, (E) a platinum group metal catalyst, and, as needs arise, (F) a reaction control agent.

[Component (A)]

The component (A) is an organopolysiloxane having the viscosity at 25°C of 0.01 to 100 Pa·s, preferably 0.03 to 10 Pa·s, and having two or more of alkenyl groups bonded to a silicon atom in one molecule. When the viscosity at 25°C is smaller than 0.01 Pa·s, the mechanical strength of a cured product is deficient, and when exceeding 100 Pa·s, the viscosity of the composition becomes too high and the fluidity becomes poor. In the present invention, the viscosity is a measurement value due to a rotary viscometer (hereinafter, the same applies.)

The (A) component that is the organopolysiloxane like this is not particularly restricted as long as the (A) component satisfies the viscosity and an alkenyl group content, well-known organopolysiloxane may be used, its structure may be also a straight chain-like or a branched chain-like, furthermore, may be a mixture of two or more kinds of organopolysiloxanes having different viscosities.

The alkenyl group that is bonded to the silicon atom contained in the (A) component of the present invention has preferably 2 to 10 carbon atoms and more preferably 2 to 8 carbon atoms, and, examples thereof include a vinyl group, an allyl group, a 1-butenyl group, and a 1-hexenyl group. Among these, from the viewpoint of easiness of synthesis, and cost, the vinyl group is preferable. Although the alkenyl group may be present at any of an end or an intermediate of a molecular chain of the organopolysiloxane, from the viewpoint of flexibility, existence at only both ends is preferable.

As an organic group other than the alkenyl group bonded to the silicon atom contained in the (A) component of the present invention, a monovalent hydrocarbon group preferably of 1 to 20 carbon atoms and more preferably of 1 to 10 carbon atoms may be used. Examples of the monovalent hydrocarbon group like this include: alkyl groups such as a methyl group, an ethyl group, a propyl group, a butyl group, a hexyl group, and a dodecyl group; an aryl group such as a phenyl group; aralkyl groups such as a 2-phenylethyl group, and a 2-phenylpropyl group; halogen-substituted

monovalent hydrocarbon groups such as a fluoromethyl group, a bromomethyl group, a chloromethyl group and a 3,3,3-trifluoropropyl group obtained by substituting a part or an entirety of hydrogen atoms of these hydrocarbon groups with a halogen atom such as chlorine, fluorine, or bromine may be used. Among these, from the viewpoint of ease of synthesis and cost, it is preferable that a methyl group is contained in 90 mol% or more.

[Component (B)]

The component (B) is a silicone resin having at least one of a $SiO_{4/2}$ unit and an $R^1SiO_{3/2}$ unit ($R^1$ is a nonsubstituted or substituted monovalent hydrocarbon group.) By containing the component (B), while maintaining the transparency intrinsic to the silicone, the strength can be imparted to the obtained cured product.
The nonsubstituted or substituted monovalent hydrocarbon group represented by $R^1$ can be a monovalent hydrocarbon group having preferably 1 to 20 carbon atoms, and more preferably 1 to 10 carbon atoms. Examples of the monovalent hydrocarbon groups like this include: alkyl groups such as a methyl group, an ethyl group, a propyl group, a butyl group, a hexyl group, and a dodecyl group; alkenyl groups such as a vinyl group, an allyl group, a 1-butenyl group and a 1-hexenyl group; aryl groups such as a phenyl group and a naphthyl group; aralkyl groups such as a 2-phenylethyl group, and a 2-phenylpropyl group; and halogen-substituted monovalent hydrocarbon groups such as a fluoromethyl group, a bromomethyl group, a chloromethyl group and a 3,3,3-trifluoropropyl group obtained by substituting a part or an entirety of hydrogen atoms of these hydrocarbon groups with a halogen atom such as chlorine, fluorine, or bromine. Among these, the methyl group, the vinyl group, and the phenyl group are preferable.
The (B) component may furthermore contain an $R^1_2SiO_{2/2}$ unit such as a methyl vinyl siloxy unit, a dimethyl siloxy unit, and an $R^1_3SiO_{1/2}$ unit such as a dimethyl vinyl siloxy unit, a trimethyl siloxy unit.
A content of the $SiO_{4/2}$ unit and/or $R^1SiO_{3/2}$ unit in the (B) component is preferably 5 mol% or larger of total siloxane units of the (B) component, more preferably 10 to 95 mol%, particularly preferably 20 to 60 mol%.
Furthermore, the (B) component is suitable to be one having a weight average molecular weight in the range of 500 to 100,000 from the viewpoint of isolation. A synthesis of the silicone resin having a resin structure like this may be readily performed by combining compounds each becoming a source unit such that product units may be a predetermined ratio and by performing (co)hydrolytic condensation under the presence of, for example, an acid.
A formulation amount of the (B) component is necessary to be set to 1 to 500 parts by mass based on 100 parts by mass of the (A) component, preferably 3 to 300 parts by mass, more preferably 5 to 100 parts by mass, and still more preferably 10 to 50 parts by mass. When the formulation amount of the (B) component is 1 part by mass or smaller, the mechanical strength is deficient, and when exceeding 500 parts by mass, the viscosity of the composition becomes too high and the fluidity is deteriorated.
The (B) component may be used singularly, or two or more kinds thereof may be used together.

[Component (C)]

The component (C) is hydrophobic silica particles. By containing the component (C), while maintaining the fluidity of the composition, the mechanical strength of the cured product may be heightened.
The (C) component has a particle diameter in the range of 20 to 1,000 nm, preferably of 20 to 500 nm, and particularly preferably of 20 to 200 nm. When the particle diameter is smaller than 20 nm, agglomerate becomes harder to lose the fluidity and transparency. Furthermore, when it is larger than 1,000 nm, the transparency is lost and an effect of improvement of the mechanical strength is also small.
The degree of hydrophobization of the (C) component in terms of the methanol titrimetric method is 60% or larger and preferably 64% or larger. In the case of the silica particles having high hydrophobicity, even when filled in the composition at high density, the agglomeration does not occur, without causing deterioration of the transparency and the fluidity, the mechanical strength of the cured product may be heightened.
The degree of hydrophobization is obtained by the methanol titrimetric method shown below.

(1) A sample is floated in a predetermined amount of ion-exchange water, with stirring, methanol is dropped.
(2) Read a dropping amount when all of the sample is suspended in the ion-exchange water.
(3) A value determined from [{methanol dropping amount (mL)}/{methanol dropping amount (mL) + ion-exchange water amount (mL)}×100] gives the degree of hydrophobization.

Although a shape of the (C) component of the present invention is not particularly limited, a spherical one is preferable.
A formulation amount of the (C) component is 10 to 500 parts by mass based on 100 parts by mass of the (A) component, preferably 20 to 200 parts by mass, and more preferably 30 to 100 parts by mass. When the formulation amount is smaller than 10 parts by mass, an effect of improvement of the mechanical strength is small, and when it

exceeds 500 parts by mass, the viscosity becomes too high and the fluidity becomes poor.

Furthermore, the (C) component is preferably one having an $R^2SiO_{3/2}$ unit wherein $R^2$ is a substituted or nonsubstituted monovalent hydrocarbon group having 1 to 20 carbon atoms and an $R^3{}_3SiO_{1/2}$ unit wherein $R^3$ is the same or different kind of substituted or nonsubstituted monovalent hydrocarbon group having 1 to 6 carbon atoms on a silica surface.

The (C) component like this may be obtained by introducing the $R^2SiO_{3/2}$ unit, next the $R^3{}_3SiO_{1/2}$ unit by hydrolysis and condensation on a surface of hydrophilic silica particles obtained by hydrolysis-condensation of, for instance, a four-functional silane compound or alkyl silicate or a mixture of these.

[Synthesis Method of Component (C)]

Specifically, the component (C) of the present invention is preferably synthesized according to the following three steps.

Step ($\alpha$): a step of synthesizing hydrophilic silica particles,
Step ($\beta$): a step of hydrophobizing treatment of a surface of the hydrophilic silica particles, and
Step ($\gamma$): a step of hydrophobizing treatment of a surface of an intermediate body of the component (C).

In what follows, each of the steps will be sequentially described.

• Step ($\alpha$): a step of synthesizing hydrophilic silica particles

It is a step of obtaining a dispersion of the hydrophilic silica particles by hydrolysis-condensation of at least one of a four-functional silane compound represented by the following general formula (I) and alkyl silicate represented by the following general formula (II) in the mixed solution of a hydrophilic organic solvent and water under the presence of a basic substance.

$$Si(OR^4)_4 \qquad (I)$$

$$Si(OR^4)_3\text{-}(\text{-}SiO(OR^4)_2\text{-})_m\text{-}Si(OR^4)_3 \qquad (II)$$

In the formulae, $R^4$s are the same or different kind of monovalent hydrocarbon group having 1 to 6 carbon atoms, m is 1 to 100.

In the general formulae (I) and (II), although the $R^4$ is the same or different kind of monovalent hydrocarbon group having 1 to 6 carbon atoms, preferably the monovalent hydrocarbon group having 1 to 4 carbon atoms, and particularly preferably monovalent hydrocarbon group having 1 to 2 carbon atoms. Examples of the monovalent hydrocarbon groups represented by the $R^4$ include alkyl groups such as a methyl group, an ethyl group, a propyl group, and a butyl group; and aryl groups such as a phenyl group, preferably a methyl group, an ethyl group, a propyl group, or a butyl group, and particularly preferably the methyl group or ethyl group.

In the general formula (II), m is 1 to 100, preferably 1 to 50, and particularly preferably 1 to 25.

Examples of the four-functional silane compound represented by the general formula (I) include: tetraalkoxysilanes such as tetramethoxysilane, tetraethoxysilane, tetrapropoxysilane, and tetrabutoxysilane; and tetraphenoxysilane, preferably tetramethoxysilane, tetraethoxysilane, tetrapropoxysilane and tetrabutoxysilane, and particularly preferably tetramethoxysilane and tetraethoxysilane. Furthermore, examples of the alkyl silicate represented by the general formula (II) include methyl silicate and ethyl silicate, preferably methyl silicate.

These may be used singularly or in a mixture of two or more kinds.

The hydrophilic organic solvent used in the step ($\alpha$) is not particularly limited as long as the solvent that dissolves the four-functional silane compound represented by the general formula (I) and/or the alkyl silicate represented by the general formula (II), and water, for example, alcohols; cellosolves such as methyl cellosolve, ethyl cellosolve, butyl cellosolve and cellosolve acetate; ketones such as acetone and methyl ethyl ketone; and ethers such as dioxane and tetrahydrofuran, preferably alcohols and cellosolves, and particularly preferably alcohols. As the alcohols, alcohols represented by the following general formula (VII) can be used.

$$R^6OH \qquad (VII)$$

In the formula, $R^6$ is a monovalent hydrocarbon group having 1 to 6 carbon atoms.

In the above formula (VII), $R^6$ is a monovalent hydrocarbon group having 1 to 6 carbon atoms, preferably having 1 to 4 carbon atoms, and particularly preferably a monovalent hydrocarbon group having 1 to 2 carbon atoms. Examples

of the monovalent hydrocarbon group represented by the $R^6$ include alkyl groups such as a methyl group, an ethyl group, a propyl group, an isopropyl group, and a butyl group, preferably the methyl group, the ethyl group, the propyl group, and the isopropyl group, more preferably the methyl group and the ethyl group. Examples of alcohols represented by the general formula (VII) include methanol, ethanol, propanol, isopropanol and butanol, preferably methanol and ethanol. As the number of carbon atoms of the alcohol increases, a particle size of produced silica particles becomes larger. Accordingly, in order to obtain silica particles having a targeted small particle size, methanol is preferable.

Furthermore, as examples of the basic substance used in the step ($\alpha$), ammonia, dimethylamine and diethylamine are cited, preferably ammonia and diethylamine are cited, and particularly preferably ammonia is cited. These basic substances, after dissolving a required amount in water, can be obtained by mixing an obtained aqueous solution (basic) with a hydrophilic organic solvent.

An amount used of the basic substance is preferably 0.01 to 2 mol, more preferably 0.02 to 0.5 mol, and particularly preferably 0.04 to 0.12 mol based on 1 mol in total of hydrocarbyloxy groups of the four-functional silane compound represented by the general formula (I) and/or alkyl silicate represented by the general formula (II). At this time, as an amount of the basic substance is smaller, silica particles having a desired small particle size are obtained. Furthermore, the basic substance may be added in the mixed solution of water and the hydrophilic organic solvent simultaneously with adding the four-functional silane compound and/or the alkyl silicate and the hydrophilic organic solvent.

An amount of water used in the hydrolysis and condensation is preferably 0.5 to 5 mol, more preferably 0.6 to 2 mol and particularly preferably 0.7 to 1 mol based on 1 mol in total of the four-functional silane compound represented by the general formula (I) and/or hydrocarbyloxy groups of the alkyl silicate represented by the general formula (II). Furthermore, a ratio of the water and hydrophilic organic solvent is preferably set to 10 to 200 parts by mass of the hydrophilic organic solvent based on 100 parts by mass of water.

Although the mixed solvent dispersion containing the obtained hydrophilic silica particles may be used as they are in the step ($\beta$), since, after addition of water in the mixed solvent dispersion containing hydrophilic silica particles, when the hydrophilic organic solvent is distilled to convert into the aqueous dispersion, remaining alkoxy groups are hydrolyzed, it is preferable to convert into an aqueous dispersion containing the hydrophilic silica particles.

In order to convert a dispersion medium of the mixed solvent dispersion of the silica particles to water, it may be performed by an operation (as needs arise, this operation is repeated) of distilling off the hydrophilic organic solvent by adding water to the dispersion, for example. An amount of water added at this time is preferably 50 to 200 parts by mass, and particularly preferably 80 to 150 parts by mass based on 100 parts by mass in total of the hydrophilic organic solvent used and an amount of alcohol generated in a synthesis step of the hydrophilic silica particles.

• Step ($\beta$): step of surface treatment of the hydrophilic silica particles

This is a step of obtaining a dispersion of the silica particles (intermediate of hydrophobic silica particles) that are an intermediate of the component (C) by adding at least one of a three-functional silane compound represented by the following general formula (III) and its (partial) hydrolysis condensate to perform surface treatment of the hydrophilic silica particles in the mixed solvent dispersion of the hydrophilic silica particles obtained in the step ($\alpha$),

$$R^2Si(OR^5)_3 \qquad (III)$$

in the formula, $R^2$ is a substituted or nonsubstituted monovalent hydrocarbon group having 1 to 20 carbon atoms, and $R^5$ is the same or different kind of a monovalent hydrocarbon group having 1 to 6 carbon atoms.

In the general formula (III), a monovalent hydrocarbon group represented by the $R^2$ is a substituted or nonsubstituted monovalent hydrocarbon group having 1 to 20 carbon atoms, preferably 1 to 3 carbon atoms, and particularly preferably a monovalent hydrocarbon group having 1 to 2 carbon atoms. Examples of the $R^2$ include alkyl groups such as a methyl group, an ethyl group, an n-propyl group, an isopropyl group, a butyl group, and a hexyl group, preferably a methyl group, an ethyl group, or an n-propyl group, and an isopropyl group, particularly preferably a methyl group and an ethyl group. Furthermore, a part or an entirety of hydrogen atoms of these monovalent hydrocarbon groups may be substituted with a halogen atom such as a fluorine atom, a chlorine atom, and a bromine atom, and a preferable one is a fluorine-substituted alkyl group.

In the general formula (III), a monovalent hydrocarbon group represented by $R^5$ is the same or different kind of monovalent hydrocarbon group having 1 to 6 carbon atoms, preferably having 1 to 3 carbon atoms, and particularly preferably a monovalent hydrocarbon group having 1 to 2 carbon atoms. Examples of the $R^5$ include alkyl groups such as a methyl group, an ethyl group, a propyl group and a butyl group, preferably a methyl group, an ethyl group and a propyl group, and particularly preferably a methyl group and an ethyl group.

Examples of the three-functional silane compounds represented by the general formula (III) include nonsubstituted or halogen-substituted trialkoxysilanes such as methyltrimethoxysilane, methyltriethoxysilane, ethyltrimethoxysilane, ethyltriethoxysilane, n-propyltrimethoxysilane, n- propyltriethoxysilane, isopropyltrimethoxysilane, isopropyltriethoxysilane, butyltrimethoxysilane, butyltriethoxysilane, hexyltrimethoxysilane, trifluoropropyltrimethoxysilane, and heptadecafluorodecyltrimethoxy silane, preferably methyltrimethoxysilane, methyltriethoxysilane, ethyltrimethoxysilane and ethyltriethoxysilane, and more preferably methyltrimethoxysilane and methyltriethoxysilane.

An addition amount of the three-functional silane compound represented by the general formula (III) is preferably 0.001 to 1 mol based on 1 mol of Si atoms of the used hydrophilic silica particles, more preferably 0.01 to 0.4 mol, and particularly preferably 0.01 to 0.2 mol. When the addition amount is 0.001 mol or larger, since the hydrophobicity of the obtained (C) component becomes higher, the dispersibility becomes excellent, and when it is 1 mol or smaller, a fear of the agglomeration of the (C) component may be suppressed.

• Step ($\gamma$): Step of surface treatment of the component (C) intermediate

This is a step of obtaining hydrophobic silica particles of the component (C) in which at least one of a silazane compound represented by the following general formula (IV) and a monofunctional silane compound represented by the following general formula (V) is added to the mixed solvent dispersion of silica particles that are intermediates of the obtained component (C) to treat a surface of the silica particles that are an intermediate of the component (C). By this step, a silanol group remaining on a surface of the hydrophobic silica particle intermediate is converted into a triorganosilyl form to introduce an $R^3{}_3SiO_{1/2}$ unit on the surface thereof.

$$R^3{}_3SiNHSiR^3{}_3 \qquad (IV)$$

$$R^3{}_3SiX \qquad (V)$$

In the formula, $R^3$ is the same or different kind of substituted or nonsubstituted monovalent hydrocarbon group having 1 to 6 carbon atoms, and X is an OH group or a hydrolyzable group.

In the general formulae (IV) and (V), a monovalent hydrocarbon group represented by $R^3$ is the same or different kind of substituted or nonsubstituted monovalent hydrocarbon group having 1 to 6 carbon atoms, preferably 1 to 4 carbon atoms, particularly preferably a monovalent hydrocarbon group having 1 to 2 carbon atoms, and examples thereof include alkyl groups such as a methyl group, an ethyl group, a propyl group, an isopropyl group and a butyl group. Preferably, a methyl group, an ethyl group and a propyl group is cited. Particularly preferably, the methyl group and the ethyl group is cited. Furthermore, a part or an entirety of hydrogen atoms of these monovalent hydrocarbon groups may be substituted with a halogen atom such as a fluorine atom, a chlorine atom and a bromine atom, preferably it is a fluorine-substituted alkyl group.

X represents an OH group or a hydrolyzable group, and examples of the hydrolyzable group include a chlorine atom, an alkoxy group, an amino group, and an acyloxy group, preferably an alkoxy group or an amino group, and more preferably an alkoxy group. A methoxy group and an ethoxy group are particularly preferable.

Examples of the silazane compounds represented by the general formula (IV) include hexamethyldisilazane, hexaethyldisilazane and tetramethyl divinyl disilazane, preferably hexamethyldisilazane.

Examples of the monofunctional silane compound represented by the general formula (V) include: monosilanol compounds such as trimethyl silanol and triethyl silanol; monochlorosilanes such as trimethylchlorosilane and triethylchlorosilane; monoalkoxysilanes such as trimethyl methoxysilane and trimethyl ethoxysilane; monoamino silanes such as trimethylsilyl dimethylamine and trimethylsilyl diethylamine; and monoacyloxy silanes such as trimethylacetoxy silane, preferably trimethyl silanol, trimethyl methoxysilane or trimethylsilyl diethylamine, and particularly preferably trimethyl silanol or trimethyl methoxysilane.

An amount used of the silazane compound and/or monofunctional silane compound is preferably 0.1 to 0.5 mol, more preferably 0.2 to 0.4 mol, and particularly preferably 0.25 to 0.35 mol based on 1 mol of Si atoms of the hydrophilic silica particles used. When the amount used is 1 mol or larger, the hydrophobicity of the obtained hydrophobic silica particles becomes higher to be excellent in the dispersibility, and, when considering the cost and so on, the amount used is sufficient to be 0.5 mol or smaller.

In order to convert a dispersion medium of the mixed solvent dispersion of the hydrophobic silica particle intermediate obtained in the step ($\beta$) from water or a hydrophilic organic solvent, or a mixture of alcohols generated during hydrolysis to a ketone-based solvent, by adding the ketone-based solvent to the dispersion, an operation (as needs arise, the operation is repeated) of distilling away water or the hydrophilic organic solvent, or the alcohol mixture may be performed. An amount of the ketone-based solvent added at this time is 50 to 500 parts by mass, preferably 100 to 300 parts by mass based on 100 parts by mass of the obtained hydrophobic silica particle intermediate. Specific examples of the ketone-based solvent used here include methyl ethyl ketone, methyl butyl ketone and acetylacetone, and particularly preferably methyl isobutyl ketone.

The component (C) obtained as shown above is converted to be obtained as powder according to ordinary

methods such as normal pressure drying, or reduced pressure drying.

[Component (D)]

The component (D) is an organohydrogenpolysiloxane having two or more of hydrogen atoms bonded to a silicon atom (Si-H group) in a molecule. This acts as a crosslinking agent that crosslinks the alkenyl groups in the component (A) or the component (B) by a hydrosilylation reaction. Although the component (D) is not particularly limited as long as an amount of the Si-H groups is satisfied, one represented by the following average composition formula (VI) is preferable.

$$R^7_aH_bSiO_{(4-a-b)/2} \qquad (VI)$$

In the formula, $R^7$ independently represents a nonsubstituted or substituted monovalent hydrocarbon group that does not contain an aliphatic unsaturated bond, "a" is the number satisfying $0.7 \le a \le 2.1$, "b" is the number satisfying $0.001 \le b \le 1.0$, provided that a+b is the number satisfying $0.8 \le a+b \le 3.0$.

In the average composition formula (VI), as the nonsubstituted or substituted monovalent hydrocarbon group that does not contain the aliphatic unsaturated bond represented by the $R^7$, the monovalent hydrocarbon group having preferably 1 to 20 carbon atoms, and more preferably 1 to 10 carbon atoms are used. Examples of the monovalent hydrocarbon group like this include: alkyl groups such as a methyl group, an ethyl group, a propyl group, a butyl group, a hexyl group, and a dodecyl group; an aryl group such as a phenyl group; aralkyl groups such as a 2-phenylethyl group, and a 2-phenylpropyl group; halogen-substituted monovalent hydrocarbon groups such as a fluoromethyl group, a bromomethyl group, a chloromethyl group and a 3,3,3-trifluoropropyl group obtained by substituting a part or an entirety of hydrogen atoms of these hydrocarbon groups with a halogen atom such as chlorine, fluorine, or bromine, preferably the methyl group or the phenyl group.

The "a", "b" and "a+b" are numbers satisfying 0.7 to 2.1, 0.001 to 1.0 and 0.8 to 3.0, respectively, and, preferably "a", "b" and "a+b" satisfy 1.0 to 2.0, 0.01 to 1.0, and 1.1 to 2.6, respectively.

The Si-H groups contained by two or more in one molecule may be located at any of molecular chain ends or the intermediates of the molecular chain, or may be located on both of the positions. Furthermore, although a molecular structure of the organohydrogenpolysiloxane may be any one of a linear, cyclic, branched, or three-dimensional network structure, the number of the silicon atoms in one molecule (or the polymerization degree) is preferably 2 to 400, more preferably 3 to 200, and particularly preferably 4 to 100.

The organohydrogenpolysiloxane of the (D) component has the viscosity at 25°C preferably of 1,000 mPa·s or smaller (normally, 1 to 1,000 mPa·s), and more preferably 5 to 200 mPa·s.

Specific examples of the organohydrogenpolysiloxane of the (D) component include 1,1,3,3-tetramethyldisiloxane, 1,3,5,7-tetramethylcyclotetrasiloxane, tris (hydrogendimethylsiloxy)methylsilane, tris (hydrogendimethylsiloxy)phenylsilane, methylhydrogencyclopolysiloxane, methylhydrogensiloxane/dimethylsiloxane cyclic copolymer, methylhydrogenpolysiloxane having both ends blocked with trimethylsiloxy groups, dimethylsiloxane/methylhydrogensiloxane copolymer having both ends blocked with trimethylsiloxy group, dimethylpolysiloxane having both ends blocked with dimethylhydrogensiloxy groups, dimethylsiloxane/methylhydrogensiloxane copolymer having both ends blocked with dimethylhydrogensiloxy groups, methylhydrogensiloxane/diphenylsiloxane copolymer having both ends blocked with trimethylsiloxy groups, methylhydrogensiloxane/diphenylsiloxane/dimethylsiloxane copolymer having both ends blocked with trimethylsiloxy groups, methylhydrogensiloxane/methylphenylsiloxane/dimethylsilo xane copolymer having both ends blocked with trimethylsiloxy groups, methylhydrogensiloxane/dimethylsiloxane/diphenylsiloxane copolymer having both ends blocked with dimethylhydrogensiloxy groups, methylhydrogensiloxane/dimethylsiloxane/methylphenylsilo xane copolymer having both ends blocked with dimethylhydrogensiloxy groups, a copolymer composed of a $(CH_3)_2HSiO_{1/2}$ unit, a $(CH_3)_3SiO_{1/2}$ unit and a $SiO_{4/2}$ unit, a copolymer composed of a $(CH_3)_2HSiO_{1/2}$ unit and a $SiO_{4/2}$ unit, and a copolymer composed of a $(CH_3)_2HSiO_{1/2}$ unit, a $SiO_{4/2}$ unit and a $(C_6H_5)_3SiO_{1/2}$ unit, other than these, ones represented by the following general formulae (VIII) to (XIII) are illustrated:

$$R^7_3SiO[SiR^7(H)O]_tSiR^7_3 \qquad (VIII)$$

$$R^7_3SiO[SiR^7(H)O]_t[SiR^7_2O]_uSiR^7_3 \qquad (IX)$$

$$R^7_2(H)SiO[SiR^7(H)O]_tSi(H)R^7_2 \qquad (X)$$

$$R^7_2(H)SiO[SiR^7_2O]_uSi(H)R^7_2 \qquad (XI)$$

$$R^7_2(H)SiO[SiR^7(H)O]_t[SiR^7_2O]Si(H)R^7_2 \qquad (XII)$$

$[SiR^7(H)O]_v$ (annulus) (XIII)

in the formulae, $R^7$ is the same as the above, t and u are integers of 1 to 100, preferably integers of 2 to 25, and v is an integer of 4 to 8.

The (D) components may be used singularly or in a combination of two or more kinds.

The formulation amount of the component (D) is an amount to provide 0.4 to 5.0 mol, preferably 0.5 to 5.0 mol, and more preferably 0.7 to 3.5 mol of the Si-H groups within the component (D) for every 1 mol of total alkenyl groups bonded to all silicon atoms contained in the composition, that is, in the component (A), the component (B) and the component (C) and so on. When the formulation amount does not satisfy an amount to provide 0.4 to 5.0 mol, a balance of the crosslinking becomes inappropriate to be unable to obtain a cured product having a high targeted tear strength.

[Component (E)]

The component (E) is a platinum group metal catalyst. The platinum group metal catalyst may be one that accelerates an addition reaction between the alkenyl groups contained in the (A) component, the (B) component and so on and the Si-H groups of the (D) component, and conventional well-known ones may be used. Among these, a catalyst selected from platinum and a platinum compound is preferable.

Examples of the catalyst like this include: platinum group simple metals such as platinum (including platinum black), rhodium, and palladium; platinum chlorides, chloroplatinic acids and chloroplatinates such as $H_2PtCl_4 \cdot nH_2O$, $H_2PtCl_6 \cdot nH_2O$, $NaHPtCl_6 \cdot nH_2O$, $KHPtCl_6 \cdot nH_2O$, $Na_2PtCl_6 \cdot nH_2O$, $K_2PtCl_4 \cdot nH_2O$, $PtCl_4 \cdot nH_2O$, $PtCl_2$, $Na_2HPtCl_4 \cdot nH_2O$ (wherein n in the formula is an integer of 0 to 6, preferably 0 or 6); alcohol-modified chloroplatinic acid, a complex of chloroplatinic acid and olefin, ones obtained by making support a platinum group metal such as platinum black and palladium on a carrier such as alumina, silica, or carbon, a rhodium-olefin complex, chlorotris(triphenylphosphine)rhodium (Wilkinson catalyst), and complexes between platinum chloride, chloroplatinic acid or chloroplatinate and vinyl group-containing siloxane. These platinum group metal catalysts may be used singularly or in a combination of two or more kinds thereof.

A formulation amount of the (E) component may be a catalytically effective amount, is not particularly limited as long as it is an amount that may promote a reaction between the (A) component, (B) component and so on and the (D) component, and may be appropriately adjusted according to a desired curing speed. The formulation amount of the (E) component is an amount to be preferably 0.1 to 7,000 ppm, more preferably 1 to 6,000 ppm relative to a mass of the (A) component, on a mass basis in terms of the platinum group metal atoms. When the formulation amount of the (E) component is 0.1 ppm or larger, an effect as the catalyst appropriately works, and when considering the cost and so on, 7,000 ppm or smaller is sufficient.

[Component (F)]

In the silicone composition of the present invention, furthermore, as the component (F), a reaction control agent may be blended. The reaction control agent may suppress a curing reaction at room temperature, and may extend the shelf life and pot life. The reaction control agent is not particularly limited as long as it can suppress the catalytic activity of the component (E), and well-known reaction control agent may be used. Examples of the reaction control agents include: acetylene compounds such as 1-ethynyl-1-cyclohexanol, 3-butyn-1-ol; various kinds of nitrogen compounds, organophosphorous compounds, oxime compounds, and organochlorine compounds. Among these, acetylene alcohol without corrosion property to the metal is preferable.

A formulation amount of the (F) component is 0.01 to 5.0 parts by mass and preferably 0.05 to 1 part by mass based on 100 parts by mass of the (A) component. When the formulation amount of the reaction control agent is smaller than 0.01 part by mass, the sufficient shelf life, pot life may not be obtained, and when the formulation amount of the reaction control agent exceeds 5.0 parts by mass, the curing property of the composition may deteriorate. The reaction control agent may be used by diluting with an organic solvent such as toluene, xylene, and isopropyl alcohol to improve the dispersibility in the silicone resin.

[Other Components]

In the silicone composition of the present invention, other than the (A) to (F) components, well-known additives may be added within the range that does not damage the object of the present invention. Examples of the additive like this include a silane coupling agent, a silicone-based/non-silicone-based adhesive aid, a hindered phenol-based antioxidant, a reinforcing, non-reinforcing filler such as calcium carbonate, and polyether as a thixotropic improver. Furthermore, as needs arise, a coloring agent such as a pigment or a dye may be added.

[Production Method of Silicone Composition]

A method for producing the silicone composition of the present invention is not particularly limited, and so-far well-known methods may be used. That is, the silicone composition of the present invention may be obtained by mixing the (A) to (E) components, and, as needs arise, other components.

The method for producing the silicone composition of the present invention particularly preferably includes a process of producing the (C) component by steps containing the following ($\alpha$), ($\beta$) and ($\gamma$), and a process of mixing at least the (C) component and (A), (B), (D), and (E) components:

($\alpha$) a step of obtaining a dispersion of hydrophilic silica particles by hydrolyzing and condensing at least one of a four-functional silane compound represented by the following general formula (I) and alkyl silicate represented by the following general formula (II) under the presence of a basic substance, in the obtained mixed solution of a hydrophilic organic solvent and water,

$$Si(OR^4)_4 \qquad (I)$$

$$Si(OR^4)_3\text{-}(\text{-}SiO(OR^4)_2\text{-})_m\text{-}Si(OR^4)_3 \qquad (II)$$

wherein, $R^4$ is the same or different kind of monovalent hydrocarbon group having 1 to 6 carbon atoms, m is 1 to 100;
($\beta$) a step of obtaining a dispersion of silica particles that are an intermediate of the (C) component by treating a surface of hydrophilic silica particles by adding at least one of a three-functional silane compound represented by the following general formula (III) and its (partial)hydrolysis condensate in the mixed solvent dispersion of the obtained hydrophilic silica particles,

$$R^2Si(OR^5)_3 \qquad (III)$$

wherein, $R^2$ is a substituted or nonsubstituted monovalent hydrocarbon group having 1 to 20 carbon atoms, and $R^5$ is the same of different kind of monovalent hydrocarbon group having 1 to 6 carbon atoms;
($\gamma$) a step of obtaining hydrophobic silica particles of the (C) component, by treating a surface of silica particles that are an intermediate of the (C) component by adding at least one of a silazane compound represented by the following general formula (IV) and a monofunctional silane compound represented by the following general formula (V) in the obtained mixed solvent dispersion of the silica particles that are an intermediate of the (C) component,

$$R^3{}_3SiNHSiR^3{}_3 \qquad (IV)$$

$$R^3{}_3SiX \qquad (V)$$

wherein, $R^3$ is the same or different kind of substituted or nonsubstituted monovalent hydrocarbon group having 1 to 6 carbon atoms, and X is an OH group or a hydrolyzable group.

Since the detailed production method of the (C) component is as was described above, it is omitted here.

A process of mixing the (A) to (E) components is not particularly limited. For example, in the case of one-pack type composition, by refrigerating or freezing, a long term storage is realized, and in the case of two-pack type composition, long term storage may be realized at normal temperature.

In the case of the one-pack type composition, for example, in a gate mixer (product name: Planetary Mixer, manufactured by Inoue MFG., INC.), the (A) component, (B) component and (C) component are taken, followed by heating and mixing at 150°C for 3 hours. After cooling the mixture, the (F) component is added, followed by mixing at room temperature for 30 minutes, further followed by adding the (D) component and (E) component and mixing at room temperature for 30 minutes to obtain the one-pack type composition.

In the case of the two-pack type composition, as long as only a combination of the (A) component, (D) component and (E) component, and a combination of the (B) component, (D)component and (E) component are not present together, an arbitrary combination may be constituted. For example, the (A) component, (B) component and (C) component are sampled in the gate mixer, and heated and mixed at 150°C for 3 hours, after cooling, the (E) component is added followed by mixing at room temperature for 30 minutes, an obtained composition is taken as a material-A, in the gate mixer, the (B) component, (D) component and (F) component are sampled, followed by mixing at room temperature for 1 hour, and an obtained composition is taken as a material-B, a two-pack type composition of the material-A and the material-B may be obtained.

The viscosity at 25°C of the silicone composition of the present invention is preferably 0.1 to 100 Pa·s, and

more preferably 1 to 50 Pa·s. When the viscosity at 25°C is 0.1 Pa·s or larger, desired mechanical strength may be obtained, and when it is 100 Pa·s or smaller, one having excellent fluidity is obtained. The viscosity is measured according to a B type rotational viscometer.

The curing condition of the present silicone composition is not particularly restricted, and the same condition as the well-known curable silicone composition may be used. Although it can be cured at room temperature, it may be cured by heating, it may be reacted at a temperature preferably of 20°C to 180°C, more preferably at a temperature of 50 to 150°C, and preferably for 0.1 to 3 hours, and more preferably for 0.5 to 2 hours.

The silicone composition of the present invention preferably has the fluidity of 60 mm or larger, the cured product preferably has the tear strength according to JIS K 6252 of 8 kN/m or larger, furthermore, it is preferable that the light transmittance at a wavelength of 800 nm of a 2 mm-thick sheet of the cured product is 80% or larger and the light transmittance at a wavelength of 400 nm is 50% or larger.

In the present invention like his, the silicone composition having high fluidity, and having high transparency and high tear strength after curing is obtained. The silicone composition of the present invention like this may be used in applications that require the fluidity and transparency, and high tear strength. It may be used, for example, as a member for optical lens, a potting agent for electronic component protection that requires the internal visibility and the crack resistance. That is, using the silicone composition of the present invention as a protection potting material of fine electronic components that generate heat gives the internal visibility that allows to find a damaged site of the component after curing, and the mechanical strength that suppresses the crack that may be generated by the thermal stress.

## EXAMPLE

In what follows, with reference to Examples and Comparative Examples, the present invention will be more detailed, however, the present invention is not limited to the following Examples. The respective components used in Examples and Comparative Examples will be described below.

Component (A)

• A-1: Organopolysiloxane represented by the following formula and having the viscosity at 25°C of 5 Pa·s

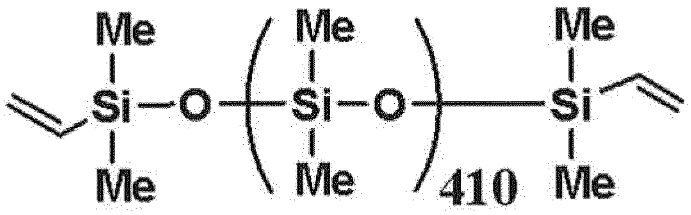

• A-2: Organopolysiloxane represented by the following formula and having the viscosity at 25°C of 5 Pa·s

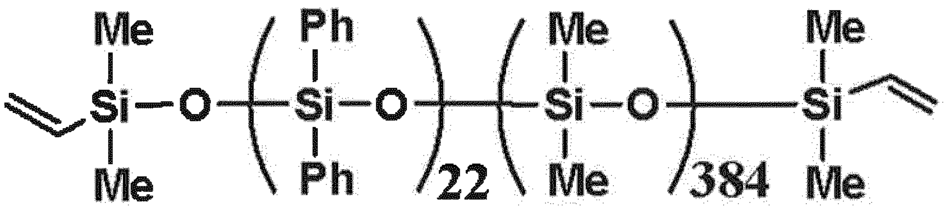

Component (B)

- B-1: A silicone resin having a methyl group and a vinyl group at both ends (Molecular structure: $Me_3SiO_{1/2}$:$Me_2ViSiO_{1/2}$:$SiO_{4/2}$ =7.4:1.3:10; Weight average molecular weight 5,300; Si-Vi amount 0.085 mol/100 g)

Component (C)

According to the following procedure, hydrophobic silica particles (C-1), (C-2), (C-3), and (C-4) were prepared.

Synthesis Example 1

- Step ($\alpha$): synthesis step of hydrophilic silica particles

In a 3L glass reactor provided with a stirrer, a dropping funnel, and a thermometer, 623.7 g of methanol, 41.4 g of water, and 49.8 g of 28 mass% ammonia water were charged and mixed. The solution was adjusted to be 35°C, while stirring, 1,163.7 g of tetramethoxysilane and 418.4 g of 5.4% ammonia water were simultaneously started to add, and were dropped over 5 hours. Even after the end of the dropping, furthermore, the stirring was continued for 0.5 hour to perform hydrolysis, and a suspension of hydrophilic spherical silica particles was obtained. An ester adapter and a cooling pipe were attached to the glass reactor, at the time when heated to 60 to 70°C to distill off 649 g of methanol, 1,600 g of water was added, followed by further heating to 70 to 90°C to distill off 160 g of methanol, and an aqueous suspension of the hydrophilic silica particles was obtained.

- Step ($\beta$): Surface treatment step of hydrophilic silica particles

To the aqueous suspension, at 25°C, 115.8 g of methyltrimethoxysilane (0.1 equivalent based on $SiO_2$) and 46.6 g of 5.4% ammonia water were dropped over 0.5 hours, followed by heating to 50°C after the dropping, further followed by aging for 1 hour. The reaction was completed and cooled to 25°C, followed by treating a surface of the hydrophilic silica particles.

- Step ($\gamma$): Step of surface treatment of (C) component intermediate

After adding 1,000 g of methyl isobutyl ketone to thus-obtained dispersion, with a violent wave state of a liquid interface kept, the dispersion was heated to 80 to 115°C to distil away 1,336 g of a mixed liquid of methanol and water over 11 hours. To the obtained dispersion, at 25°C, 357.4 g of hexamethyldisilazane was added, followed by heating the dispersion to 120°C to make react for 3 hours to perform trimethylsilylation to the silica particles to obtain hydrophobized silica particles. Thereafter, the solvent was distilled away under heating by an evaporator to obtain 477 g of the hydrophobized silica particles (C-1).

Synthesis Example 2

470 g of the hydrophobized silica particles (C-2) was obtained in the same manner except that 1,163.7 g of tetramethoxysilane was changed to 901.9 g of methyl silicate (Methyl Silicate 51, manufactured by Colcoat Co.) among the step ($\alpha$) of Synthesis Example 1.

Synthesis Example 3

360 g of the hydrophobized silica particles (C-3) was obtained in the same manner except that an amount of methyltrimethoxysilane used was changed to 11.6 g (corresponding to 0.01 equivalent based on $SiO_2$) among the step ($\beta$) of Synthesis Example 1.

Comparative Synthesis Example 1

In a 3L glass reactor provided with a stirrer, a dropping funnel and a thermometer, 60 g of isopropanol, and 100 g of SNOWTEX OL (average particle size: 50 nm, solid content concentration dispersed in water: 20%, manufactured by Nissan Chemical Corporation) that is one kind of colloidal silica as silica particles were added and stirred. To the solution, 0.48 g of methyltrimethoxysilane was dropped over 0.5 hour, after dropping, heated to 50°C, followed by aging for 1 hour. After completion of the reaction, followed by cooling to 25°C, further followed by treating a surface of the silica particles.

Subsequently, 0.78 g of hexamethyldisilazane was added, followed by heating the dispersion to 105°C to react for 2 hours. Finally, 2.6 parts by mass of an aqueous solution of 35% hydrochloric acid was added to precipitate silica particles. Thereafter, the solvent was distilled away by an evaporator under heating to obtain the hydrophobic silica particles (C-4).

Measurement Method

Of the obtained hydrophobic silica particles, measurements were performed according to the following measurement methods 1 to 2. Obtained results are shown in Table 1.

1. Particle size measurement of hydrophobic silica particles

(1) 0.1 g of a sample was taken in a glass bottle, followed by stirring with 20 g of methanol added.
(2) A ultrasonic disperser was used for 10 minutes to disperse, thus a measurement sample was obtained.
(3) With a laser analysis scattering type particle size analyzer (Product name: Nanotrac 150, manufactured by Nikkiso Co., Ltd.), the sample of (2) was measured, and a median diameter based on volume (a particle size corresponding to cumulative 50% when a particle size distribution is expressed as a cumulative distribution) was taken as a particle size.

2. A degree of hydrophobization measurement of hydrophobic silica particles (methanol titrimetric method)

(1) 0.2 g of the sample was measured in a 500 mL Erlenmeyer flask.

(2) With 50 mL of ion-exchange water added to the (1), followed by stirring with a stirrer.

(3) While stirring, methanol was dropped from a burette, and a dropping amount when an entire amount of the sample was suspended in ion-exchange water was read.

(4) The degree of hydrophobization was obtained according to the following formula.

$$\text{Degree of hydrophobization (\%)} = \{\text{dropping amount of methanol (mL)}\}/\{\text{dropping amount of methanol (mL)} + \text{amount of ion-exchange water (mL)}\} \times 100$$

[Table 1]

| | Synthesis Example 1 | Synthesis Example 2 | Synthesis Example 3 | Comparative Synthesis Example 1 |
|---|---|---|---|---|
| Hydrophobic silica particles | (C-1) | (C-2) | (C-3) | (C-4) |
| Particle size (nm) | 87 | 82 | 113 | 50 |
| Degree of hydrophobization | 67 | 67 | 66 | 58 |

Component (D)

• D-1: Organohydrogensiloxane represented by the following formula

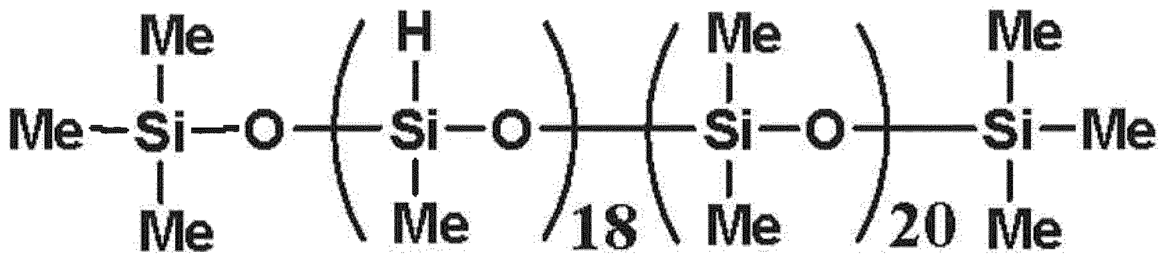

• D-2: Organohydrogensiloxane represented by the following formula

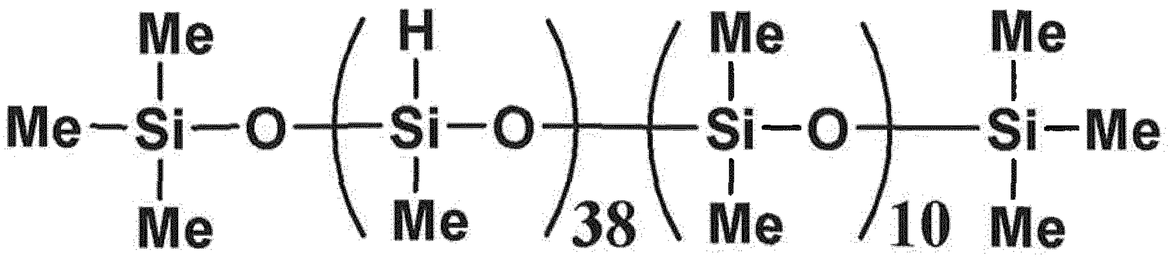

Component (E)

• E-1: A dimethylpolysiloxane solution of a platinum-divinytetramethyldisiloxane complex (One obtained by dissolving in dimethylpolysiloxane that has both ends blocked with a dimethyl vinyl silyl group and has the viscosity at 25°C of 0.6 Pa·s. Platinum atoms are contained by 1 mass%.)

Component (F)

• F-1: 1-ethynyl-1-cyclohexanol

Examples 1 to 6 and Comparative Examples 1 to 3 Preparation of Silicone Composition

In the gate mixer (5L Planetary Mixer, manufactured by Inoue MFG., INC.), the (A) component, (B) component and (C) component were added at formulation amounts shown in Tables 2, 3, followed by heating and mixing at 150°C for 3 hours. Next, the (F) component was added at a formulation amount shown in Tables 2, 3, and mixed at 25°C for 30 minutes. Finally, the (D) component and (E) component were added at the formulation amount shown in Tables 2,3, and mixed at 25°C for 30 minutes so as to be uniform. Of the obtained respective compositions, each of physical properties was measured according to the methods shown below. Results are shown together in Tables 2,3.

Viscosity

The viscosity at 25°C of each of silicone compositions was measured with a B-type viscometer.

Fluidity

0.60 $cm^3$ of each of the silicone compositions was sampled and dropped on an aluminum plate (JIS H4000, 0.5×25×250 mm). After that, the aluminum plate was inclined at 28 degree, left under a 23°C (±2°C) atmosphere, and a length between both ends of the silicone composition after 1 hour was measured.

Hardness

Each of the silicone compositions was press-cured at 120°C for 10 minutes, furthermore followed by heating in an oven set at 120°C for 50 minutes. With three sheets of the obtained silicone sheets having a thickness of 2.0 mm stacked, the hardness was measured by a type A durometer according to JIS K 6253.

Tensile strength, Elongation at break

Each of the silicone compositions was press-cured at 120°C for 10 minutes, followed by further heating in an oven set at 120°C for 50 minutes. The tensile strength and elongation at break of the obtained silicone sheet having a thickness of 2.0 mm were measured according to JIS K 6251.

Tear strength

Each of the silicone compositions was press-cured at 120°C for 10minutes, further heated in an oven set at 120°C for 20 minutes. The tear strength of the obtained silicone sheet having a thickness of 2.0 mm was measured according to JIS K 6252.

Light Transmittance

Each of the silicone compositions was flowed in a mold obtained by combining glass sheets so as to be a thickness of 2 mm, heated in a dryer at 120°C for 30 minutes, and a sample for measuring light transmittance was obtained. With a spectrophotometer (U-3310, manufactured by Hitachi Corporation), light transmittances at wavelengths of 800 nm and 400 nm were measured.

Table 2

| | | | Example 1 | Example 2 | Example 3 | Example 4 | Example 5 | Example 6 |
|---|---|---|---|---|---|---|---|---|
| Formulation amount (parts by mass) | (A) Component | A-1<br>A-2 | 100<br>0 | 0<br>100 | 0<br>100 | 0<br>100 | 0<br>100 | 0<br>100 |
| | (B) Component | B-1 | 13 | 13 | 8 | 18 | 18 | 23 |
| | (C) Component | C-1<br>C-2<br>C-3<br>C-4 | 84<br>0<br>0<br>0 | 0<br>84<br>0<br>0 | 112<br>0<br>0<br>0 | 0<br>74<br>0<br>0 | 0<br>0<br>144<br>0 | 0<br>0<br>102<br>0 |
| | (D) Component | D-1<br>D-2 | 3.6<br>0 | 0<br>3.6 | 0<br>3. 6 | 0<br>3.6 | 0<br>4.8 | 0<br>5.1 |
| | (E) Component | E-1 | 0.5 | 0.5 | 0.5 | 0.5 | 0.5 | 0.5 |
| | (F) Component | F-1 | 0.06 | 0.06 | 0.06 | 0.06 | 0.06 | 0.06 |
| Evaluation Results | Viscosity (Pa·s) | | 47 | 20 | 56 | 22 | 118 | 28 |
| | Fluidity (mm) | | 75 | 210 | 142 | 219 | 110 | 184 |
| | Tear Strength (kN/m) | | 10.4 | 11.7 | 15.7 | 15.5 | 10.8 | 8.1 |
| | Light Transmittance at 800 nm (%) | | 82.1 | 92.1 | 91.7 | 92.5 | 93.0 | 91.7 |
| | Light Transmittance at 400 nm (%) | | 54.7 | 86.0 | 76.8 | 87.4 | 84.9 | 87.7 |
| | Hardness (type A) | | 40 | 42 | 39 | 38 | 54 | 58 |
| | Tensile Strength (MPa) | | 3.6 | 3.4 | 4.3 | 4.6 | 4.2 | 4.6 |
| | Elongation at break (%) | | 280 | 200 | 280 | 220 | 210 | 160 |

Table 3

| | | | Comparative Example 1 | Comparative Example 2 | Comparative Example 3 |
|---|---|---|---|---|---|
| Formulation amount (parts by mass) | (A) Component | A-1<br>A-2 | 0<br>100 | 100<br>0 | 0<br>100 |
| | (B) Component | B-1 | 7 | 0 | 13 |
| | (C) Component | C-1<br>C-2<br>C-3<br>C-4 | 0<br>0<br>0<br>0 | 0<br>80<br>0<br>0 | 0<br>0<br>0<br>84 |
| | (D) Component | D-1<br>D-2 | 0<br>1. 9 | 3.4<br>0 | 0<br>3.6 |
| | (E) Component | E-1 | 0.5 | 0.5 | 0.5 |
| | (F) Component | F-1 | 0.06 | 0.06 | 0.06 |
| Evaluation Results | Viscosity (Pa·s) | | 5 | 33 | 38 |
| | Fluidity (mm) | | 240 | 53 | 126 |
| | Tear Strength (kN/m) | | 0.7 | 3.4 | 4.8 |
| | Light Transmittance at 800 nm (%) | | 94.1 | 85.8 | 15.6 |
| | Light Transmittance at 400 nm (%) | | 93.6 | 44.6 | 10.6 |
| | Hardness (type A) | | 25 | 25 | 63 |
| | Tensile Strength (MPa) | | 0.8 | 2. 6 | 5.2 |
| | Elongation at break (%) | | 130 | 490 | 110 |

As shown in Table 2, the silicone compositions of the present invention prepared in Examples 1 to 6 exhibit excellent fluidity of 60 mm or larger, and their cured products have the tear strength according to JIS K 6252 of 8 kN/m or larger, and furthermore, a 2 mm thick sheet had the light transmittance at a wavelength of 800 nm of 80% or larger and the light transmittance at a wavelength of 400 nm of 50% or larger, and high tea strength and high transparency.

On the other hand, as shown in Table 3, in the Comparative Example 1 that does not contain the (C) component, the tear strength was deficient to be poor in the mechanical characteristics. In the Comparative Example 2 that does not contain the (B) component, the fluidity, the tear strength and the transparency were poor. Furthermore, in Comparative Example 3 where the (C) component deficient in the degree of hydrophobization was used, the tear strength was poor, and the transparency was remarkably damaged.

From what was described above, it was obvious that according to the present invention, the silicone compositions having excellent fluidity like this, and high transparency and high tear strength after curing were obtained.

It is to be noted that the present invention is not restricted to the foregoing embodiment. The embodiment is just an exemplification, and any examples that have substantially the same feature and demonstrate the same functions and effects as those in the technical concept described in claims of the present invention are included in the technical scope of the present invention.

## Claims

**1.** A silicone composition comprising the following (A) to (E) components:

(A) 100 parts by mass of an organopolysiloxane having the viscosity at 25°C of 0.01 to 100 Pa·s and two or more alkenyl groups bonded to a silicon atom in one molecule;
(B) 1 to 500 parts by mass of a silicone resin having at least one of a $SiO_{4/2}$ unit and a $R^1SiO_{3/2}$ unit ($R^1$ is a nonsubstituted or substituted monovalent hydrocarbon group);
(C) 10 to 500 parts by mass of hydrophobic silica particles having an average particle diameter in the range of 20 nm to 1,000 nm, and a degree of hydrophobization due to a methanol titrimetric method of 60% or larger;
(D) an organohydrogenpolysiloxane having two or more hydrogen atoms bonded to a silicon atom in one molecule, in an amount to provide 0.4 to 5.0 mol of the silicon-bonded hydrogen atoms within the (D) component for every 1 mol of a total of the alkenyl groups bonded to all silicon atoms in the composition; and
(E) an effective amount of a platinum group metal catalyst.

**2.** The silicone composition according to claim 1, wherein the (C) component is one having a $R^2SiO_{3/2}$ unit ($R^2$ is a substituted or nonsubstituted monovalent hydrocarbon group having 1 to 20 carbon atoms) and a $R^3{}_3SiO_{1/2}$ unit ($R^3$ is the same or different kind of substituted or nonsubstituted monovalent hydrocarbon group having 1 to 6 carbon atoms) on a silica surface.

**3.** The silicone composition according to claim 1 or claim 2, wherein furthermore (F) a reaction control agent is contained in the range of 0.01 to 5.0 parts by mass based on 100 parts by mass of the (A) component.

**4.** A method for producing the silicone composition according to any one of claim 1 to 3, comprises a process of producing the (C) component by steps containing the following ($\alpha$), ($\beta$) and ($\gamma$), and a process of mixing at least the (C) component and the (A), (B), (D), and (E) components:

($\alpha$) a step of obtaining a dispersion of hydrophilic silica particles by hydrolyzing and condensing at least one of a four-functional silane compound represented by the following general formula (I) and alkyl silicate represented by the following general formula (II) under the presence of a basic substance, in a mixed solution of a hydrophilic organic solvent and water,

$$Si(OR^4)_4 \qquad (I)$$

$$Si(OR^4)_3\text{-}(\text{-}SiO(OR^4)_2\text{-})_m\text{-}Si(OR^4)_3 \qquad (II)$$

wherein, $R^4$ is the same or different kind of monovalent hydrocarbon group having 1 to 6 carbon atoms, m is 1 to 100;
($\beta$) a step of obtaining a dispersion of silica particles that are an intermediate of the (C) component by treating a surface of the hydrophilic silica particles by adding at least one of a three-functional silane compound represented by the following general formula (III) and its (partial)hydrolysis condensate in the obtained mixed solvent dispersion of the hydrophilic silica particles,

$$R^2Si(OR^5)_3 \qquad (III)$$

wherein, $R^2$ is a substituted or nonsubstituted monovalent hydrocarbon group having 1 to 20 carbon atoms, and $R^5$ is the same or different kind of monovalent hydrocarbon group having 1 to 6 carbon atoms;
($\gamma$) a step of obtaining hydrophobic silica particles of the (C) component, by treating a surface of silica particles that are an intermediate of the (C) component by adding at least one of a silazane compound represented by the following general formula (IV) and a monofunctional silane compound represented by the following general formula (V) in the obtained mixed solvent dispersion of the silica particles that are an intermediate of the (C) component,

$$R^3{}_3SiNHSiR^3{}_3 \qquad (IV)$$

$$R^3{}_3SiX \qquad (V)$$

wherein, $R^3$ is the same or different kind of substituted or nonsubstituted monovalent hydrocarbon group having 1 to 6 carbon atoms, and X is an OH group or a hydrolyzable group.

## INTERNATIONAL SEARCH REPORT

International application No. PCT/JP2018/017012

A. CLASSIFICATION OF SUBJECT MATTER

Int.Cl. C08L83/07(2006.01)i, C08K3/36(2006.01)i, C08K9/06(2006.01)i, C08L83/04(2006.01)i, C08L83/05(2006.01)i

According to International Patent Classification (IPC) or to both national classification and IPC

B. FIELDS SEARCHED

Minimum documentation searched (classification system followed by classification symbols)

Int.Cl. C08L83/07, C08K3/36, C08K9/06, C08L83/04, C08L83/05

Documentation searched other than minimum documentation to the extent that such documents are included in the fields searched

| | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2014-40522 A (SHIN-ETSU CHEMICAL CO., LTD.) 06 March 2014, claim 1, paragraphs [0009], [0038] (Family: none) | 1, 3<br>2, 4 |
| Y | JP 2000-44226 A (SHIN-ETSU CHEMICAL CO., LTD.) 15 February 2000, claims 1-3, 6, paragraphs [0003], [0019] & US 6521290 B1, claims 1-2, column 1, lines 58-67, example 1 & EP 959102 A2 & DE 69927427 T2 | 2, 4 |
| A | JP 2016-138011 A (DENKA CO., LTD.) 04 August 2016, claims 1, 3, paragraphs [0027], [0028] (Family: none) | 1-4 |

☐ Further documents are listed in the continuation of Box C. ☐ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 03 July 2018 (03.07.2018) | 17 July 2018 (17.07.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008231247 A
- JP 2000351901 A
- JP 2013064089 A
- JP 2012144595 A